# EUROPÄISCHE PATENTSCHRIFT

(11) **EP 3 904 896 B1**
(45) Veröffentlichungstag und Bekanntmachung des Hinweises auf die Patenterteilung: **13.03.2024**
(21) Anmeldenummer: 21169290.0
(22) Anmeldetag: 20.04.2021
(51) Int. Cl.: G01R 31/52, G01R 35/00

(54) **ELEKTRISCHE SCHALTUNGSANORDNUNG UND VERFAHREN ZUR FUNKTIONSPRÜFUNG EINES ÜBERWACHUNGSGERÄTS FÜR EIN ELEKTRISCHES STROMVERSORGUNGSSYSTEM**
ELECTRICAL CIRCUIT ARRANGEMENT AND METHOD FOR TESTING A MONITORING DEVICE FOR AN ELECTRONIC POWER SUPPLY SYSTEM
CIRCUIT ÉLECTRIQUE ET PROCÉDÉ D'ESSAI FONCTIONNEL D'UN APPAREIL DE SURVEILLANCE POUR UN SYSTÈME D'ALIMENTATION ÉLECTRIQUE

(30) Priorität: 30.04.2020 DE 102020111807
(43) Veröffentlichungstag der Anmeldung: 03.11.2021
(73) Patentinhaber: Bender GmbH & Co. KG, 35305 Grünberg (DE)
(72) Erfinder: REITZ, Julian, 35305 Grünberg (DE); SCHEPP, Karl, 35447 Reiskirchen (DE)
(74) Vertreter: advotec.

(56) Entgegenhaltungen:
- EP-A1- 1 162 470
- EP-A1- 3 641 087
- DE-A1-102014 217 370
- US-A- 3 868 665

## Beschreibung

Die Erfindung betrifft eine elektrische Schaltungsanordnung und ein Verfahren zur Funktionsprüfung eines Überwachungsgerätes für ein elektrisches Stromversorgungssystem, mit einem Prüfwiderstand, der zwischen einen aktiven Leiter des Stromversorgungssystems und Erde schaltbar ist und einen einstellbaren Widerstands-Istwert aufweist.

Des Weiteren betrifft die Erfindung eine modulare Schaltungsanordnung bestehend aus mehreren erfindungsgemäßen elektrischen Schaltungsanordnungen.

Sicherheitsvorschriften für elektrische Anlagen wie beispielsweise Stromversorgungssysteme und daran angeschlossene Betriebsmittel sowie Anforderungen an Schutzmaßnahmen zur Gewährleistung der elektrischen Sicherheit gewinnen in einer auf der Versorgung mit elektrischer Energie beruhenden Volkswirtschaft zunehmend an Bedeutung. Dabei ist nicht nur die richtige Auswahl geeigneter Überwachungsgeräte, sondern auch deren einwandfreie Funktion entscheidend, um (Isolations-)Fehler frühzeitig zu erkennen und dadurch entstehende Ausfallzeiten der elektrischen Anlage und damit verbundene Kosten zu vermeiden.

Zur Überwachung eines ungeerdeten Stromversorgungssystems (frz. auch Isolé Terre - IT-Netz) ist daher gemäß der Norm IEC 61557-8 ein Isolationsüberwachungsgerät (IMD) als Überwachungseinrichtung vorgeschrieben. In geerdeten Stromversorgungssystemen erfolgt die Überwachung gemäß der Norm IEC 62020 mittels einer Differenzstrom-Überwachungseinrichtung (RCM).

Diese Überwachungsgeräte müssen daher mittels Erstinbetriebnahmeprüfung und über die gesamte Einsatzdauer in wiederkehrenden Prüfungen mit festgelegten Prüfintervallen auf eine normgerechte Funktion überprüft werden.

Messverfahren zur Bestimmung des Isolationswiderstands in ungeerdeten Stromversorgungssystemen beruhen prinzipiell auf der Überlagerung einer in dem Isolationsüberwachungsgerät erzeugten Messspannung, sodass sich ein dem Isolationsfehler (Fehlerwiderstand) proportionaler Messstrom einstellt, der an einem Messwiderstand des Isolationsüberwachungsgerätes einen entsprechenden Spannungsabfall hervorruft. Überschreitet der Spannungsabfall infolge eines abgesunkenen Isolationswiderstands und damit eines höheren Messstroms einen bestimmten Wert, so wird eine Meldung ausgelöst.

Zur Funktionsprüfung des normgemäßen Isolationsüberwachungsgerätes wird als Fehlerwiderstand ein Prüfwiderstand mit einem definierten Widerstandswert in das von dem Isolationsüberwachungsgerät überwachte Netz zwischen einen oder mehreren aktiven Leiter(n) und Erde eingebracht.

Die Wirkungsweise eines Differenzstrom-Überwachungsgerätes in geerdeten Stromversorgungssystemen beruht auf der Tatsache, dass im fehlerfreien Betrieb der elektrischen Anlage die vektorielle Summe der Ströme auf allen aktiven Leitern einer Zuleitung gleich Null ist und somit auch kein Magnetfeld in einem die Zuleitung umschließenden magnetisierbaren Ringkern eines Messstromwandlers des Differenzstrom-Überwachungsgerätes existiert. Entsteht aufgrund eines Isolationsfehlers ein Fehlerstrom, der außerhalb der Zuleitung über einen Körper bzw. über Erde abfließt, ergibt sich ein Differenzstrom. Das veränderliche Magnetfeld dieses Differenzstroms induziert in einer Sekundärspule des Messstromwandlers eine Spannung, die ein Alarmsignal auslöst, wenn ein vorgewählter Wert des Differenzstroms überschritten wird.

Zur Funktionsprüfung des normgemäßen Differenzstrom-Überwachungsgerätes ist als Fehlerwiderstand ein Prüfwiderstand mit definiertem Widerstandswert zu schalten, der einen künstlichen, an dem Ringkern des Differenzstrom-Überwachungsgerätes "vorbeigeführten" Fehlerstrom erzeugt.

Aus der Patentschrift EP 3 246 715 B1 sind ein Verfahren und eine Vorrichtung zur Funktionsprüfung eines Isolationsüberwachungsgerätes bekannt, bei dem in sich wiederholenden Prüfzyklen zwei unterschiedliche Isolationswiderstände (Fehlerwiderstände) geschaltet werden und die Reaktion des Isolationsüberwachungsgerätes, also der augenblickliche Betriebszustand, ausgewertet wird.

Von der Firma Gossen Metrawatt ist eine Prüfvorrichtung (Prüfgerät) bekannt (http://www.gmc-instuments.de/media/de/product_manual/profi-test-master-seculifeip-iq-ba_d.pdf), bei dem zur Funktionsprüfung des Isolationsüberwachungsgerätes einphasige Fehler mit diskreten Widerstandswerten und manueller Auslösezeit-Erfassung generiert werden können.

Weiterhin sind auf dem Markt sogenannte "Fehlerstecker" verfügbar, die einen eingebauten Fehlerwiderstand gegen Erde schalten. Dabei werden bei Serviceeinsätzen große, schwere und je nach Anwendung elektrisch unsichere Widerstandsdekaden zur Fehlererzeugung eingesetzt.

Sämtliche vorgenannten aus dem Stand der Technik bekannten Lösungen weisen den Nachteil auf, dass nur diskrete Widerstandswerte schaltbar sind. Da aber vor allem hochwertige Isolationsüberwachungsgeräte über eine Vielzahl spezieller Messprofile verfügen, genügt es im Hinblick auf die Gewährleistung der funktionalen Sicherheit nicht, mit nur einem bestimmten Widerstandswert oder einer zeitlichen Abfolge diskreter Widerstandswerte zu messen. Vielmehr sind für einen Funktionstest Widerstandsverläufe von Interesse, welche ein reales Systemverhalten der elektrischen Anlage einschließlich des Auftretens symmetrischer Fehler simulieren können, wobei das Auf- und Abschalten der Fehlerwiderstände (Prüfwiderstände) nicht zu einer unzulässigen Strombelastung der elektrischen Anlage führen darf.

Aus der Patentschrift DE 10 2018 125 004 B3 ist eine mittels eines Regelkreises gesteuerte Änderung des Widerstandswertes einer Transistor-Kaskade bekannt. Diese Transistor-Kaskade wirkt nicht als Prüfwiderstand, sondern als Ankoppelimpedanz für ein Isolationsüberwachungsgerät, wobei ein sanftes Auf- und Abschalten der Ankoppelimpedanz zur Vermeidung von Überströmen nicht vorgesehen ist. Weitere Nachteile der verfügbaren Prüfvorrichtungen bestehen darin, dass häufig manuelle Eingriffe zur Aufnahme einer Messgröße, beispielsweise der Auslösezeit, erforderlich sind.

Zudem sind bekannte Prüfvorrichtungen oftmals aufgrund ihrer Baugröße und des hohen Gewichtes für den mobilen Einsatz ungeeignet. Weiterer relevanter Stand der Technik findet sich in US 3 868 665 A, DE 10 2014 217370 A1 und EP 1 162 470 A1.

Der vorliegenden Erfindung liegt somit die Aufgabe zugrunde, eine elektrische Schaltungsanordnung und ein Verfahren zur Funktionsprüfung eines Überwachungsgerätes für ein Stromversorgungssystem, insbesondere eines Isolationsüberwachungsgerätes und eines Differenzstrom-Überwachungsgerätes, zu schaffen. Die erfindungsgemäße technische Lehre soll (technisch) flexibel an die Messumgebung und die Messaufgabe anpassbar sein, wobei die elektrische Schaltungsanordnung auch in Bezug auf Baugröße und Gewicht kostengünstig herstellbar und flexibel (ökonomisch) einsetzbar sein soll.

Diese Aufgabe wird erfindungsgemäß durch die in Anspruch 1 definierte elektrische Schaltungsanordnung gelöst.

Die mit der Erfindung verwirklichte erfinderische Idee besteht erstens darin, als Prüfwiderstand eine aus Feldeffekttransistoren bestehende bidirektionale Kaskade anstelle diskreter ohmscher Widerstände zu verwenden, wobei die Feldeffekttransistoren nicht wie technisch üblich als Schalter, sondern als veränderbarer ohmscher Widerstand eingesetzt werden. Die bidirektionale Kaskade besteht aus einer Reihenschaltung von zwei spiegelbildlich angeordneten Feldeffekttransistoren.

Im Leistungsbetrieb können die Feldeffekttransistoren nicht im linearen Betriebsbereich, sondern nahezu ausschließlich im Sättigungsbereich betrieben werden. Daher wird die Feldeffekttransistor-Kaskade von einem analogen Regelkreis in ein ohmsches Verhalten bei Sättigungsbetrieb gezwungen und arbeitet aufgrund der Bidirektionalität im ersten und dritten Quadranten eines Kennlinienfeldes der Feldeffekttransistor-Kaskade. Damit ist sowohl Gleichspannungs- als auch Wechselspannungsbetrieb möglich.

Ein zweites Kernelement der Erfindung ist die analoge Regelung mittels eines Regelkreises zur wertkontinuierlichen Einstellung des Widerstandswertes für den Prüfwiderstand. Mit einer gesteuerten Widerstandsänderung wird der Widerstandswert der aus Feldeffekttransistoren bestehenden bidirektionalen Kaskade in einem geschlossenen Wirkungskreis auf einen vorgebbaren Widerstands-Sollwert geregelt. Der Regelkreis steuert die Feldeffekttransistoren in ihrem Kennlinienfeld so an, dass eine ohmsche Widerstandskennlinie entsteht.

Die erfindungsgemäße Kombination der Feldeffekttransistor-Kaskade und deren analoge Regelung bildet aus schaltungstechnischer Sicht ein wertkontinuierliches Äquivalent zu einer diskret veränderlichen Einstellung des Widerstandswertes.

Neben dem rein technischen Vorteil der durch die wertkontinuierliche Einstellung des Widerstandswertes ermöglichten Einsatzflexibilität besteht auch ein technisch-wirtschaftlicher Vorteil darin, dass durch die Verwendung von nur zwei Feldeffekttransistoren anstatt vieler einzelner Widerstände die Baugröße und das Gewicht stark minimiert werden und somit der Materialaufwand gesenkt werden kann. Dieser Aspekt kommt insbesondere bei Leistungsanwendungen in Stromversorgungssystemen, wie bei der Einprägung ohmscher Fehlerwiderstände zwischen einem aktiven Leiter und Erdpotenzial, zum Tragen.

Weiterhin ist in technischer Hinsicht von Vorteil, dass aufgrund der analogen Regelung eine theoretisch unendlich feine Auflösung des einstellbaren Widerstandswertes erreicht werden kann, welcher letztlich nur durch die Auflösung der digitalen Sollwert-Vorgabe bestimmt wird. Die Änderung des Widerstandswertes kann aufgrund der analogen Regelung in vorteilhafterweise sowohl wertkontinuierlich als auch zeitkontinuierlich vollzogen werden, da keine Schaltvorgänge stattfinden. Dies ist bei bekannten diskret geschalteten Widerstandsdekaden nicht ohne weiteres möglich.

Durch die stufenlose Einstellung der Widerstandswerte wird ein wert- und zeitkontinuierlicher (Fehler-)Widerstandsverlauf zur Prüfung der Überwachungsfunktion ermöglicht, bei dem ein reales Systemverhalten nachgestellt werden kann.

Erfindungsgemäß weist die Regelung auf: Einen Transformationsblock, welcher mittels eines Ist-Stroms den vorgebbaren Widerstands-Sollwert in eine Soll-Spannung als Führungsgröße transformiert;
eine Strommessung, welche einen durch die Transistor-Kaskade fließenden Transistor-Strom erfasst und skaliert als den Ist-Strom in den Transformationsblock zurückführt;
ein Vergleichsglied, welches die Soll-Spannung mit einer Ist-Spannung vergleicht und eine Differenzspannung als Regelabweichung bildet; eine Spannungsmessung, welche eine über der Transistor-Kaskade abfallende Transistor-Spannung erfasst und skaliert als die Ist-Spannung in das Vergleichsglied zurückführt;
einen Regler, der aus der Differenzspannung eine Stellgröße zur Ansteuerung einer Regelstrecke erzeugt, die durch die Transistor-Kaskade mit dem Widerstandswert als Regelgröße gebildet ist;
eine steuerbare Schalteinrichtung, welche die Ist-Spannung auf den Wert Null schaltet, um die Regelung herunterzufahren.

Der als bidirektionale Transistor-Kaskade ausgebildete Prüfwiderstand mit dem veränderlichen Widerstandswert als Regelgröße bildet die Regelstrecke des Regelkreises. Innerhalb der Regelstrecke ist der bidirektionalen Transistor-Kaskade eine Transistor-Treiberschaltung vorgeschaltet, die durch die von dem Regler bereitgestellte Stellgröße angesteuert wird.

Der Regler wiederum erzeugt die Stellgröße aus der Differenzspannung, die in dem Vergleichsglied erzeugt wird.

Die Differenzspannung stellt die Regelabweichung zwischen der Soll-Spannung und der Ist-Spannung dar, wobei die Spannungsmessung die über der Transistor-Kaskade abfallende Transistorspannung erfasst und skaliert als Ist-Spannung in das Vergleichsglied zurückführt.

Die Soll-Spannung wird als Führungsgröße aus einem vorgebbaren Soll-Widerstandswert mittels des Ist-Stroms in dem Transformationsblock ermittelt.

Durch die Strommessung wird der durch die Transistor-Kaskade fließende Transistorstrom ermittelt und skaliert als Ist-Strom dem Transformationsblock zugeführt.

Zur Einstellung eines gewünschten Widerstandswertes für den Prüfwiderstand wird der Regelung ein Sollwert des Widerstandswertes vorgegeben. Der gewünschte Widerstandswert stellt sich in dem Regelkreis mittels Rückkopplung der Strommessung des in der Transistor-Kaskade fließenden Transistorstroms und mittels Rückkopplung der Spannungsmessung der über der Transistor-Kaskade abfallenden Transistorspannung ein.

Da der Prüfwiderstand, also die bidirektionale Transistor-Kaskade, zwischen dem aktiven Leiter und Erde angeschlossen ist, wirkt die Leiter-Erde-Spannung als auf die Regelstrecke einwirkende Störgröße, sodass die Stellgröße zum Einhalten des Widerstands-Sollwertes in einem Wechselspannungs-Stromversorgungssystem fortlaufend nachgeführt werden muss. In einem reinen Gleichspannungs-Stromversorgungssystem mit konstanter Spannung wäre die Stellgröße für einen vorgegebenen Widerstands-Sollwert hingegen konstant.

Um die Regelung herunterzufahren, also den Widerstandswert gegen Unendlich zu schalten - gleichbedeutend mit einem verschwindenden Stromfluss über die Transistor-Kaskade - wird in der steuerbaren Schalteinrichtung die Ist-Spannung auf den Wert Null geschaltet.

Ein Abschalten der Regelung erfolgt somit dadurch, dass die Ist-Spannung - der Ausgang der Spannungsmessung - auf das Massepotential gezogen wird. Der PI-Regler (siehe unten) wird die Regelabweichung so lange durch das Herunterfahren der Stellgröße reduzieren, bis diese Regelabweichung konstant null ist.

Wird für ein erneutes Hochfahren der Regelung die Ist-Spannung durch Schließen der steuerbaren Schalteinrichtung wieder freigegeben, so ist die Regelabweichung aufgrund des fehlenden Ist-Stroms zunächst negativ. Dem folgt der PI-Regler dann mit einem kontinuierlichen Erhöhen der Stellgröße bis die Regelabweichung wieder bei null ist.

Aufgrund dessen, dass sich die Stellgröße bei dem PI-Regler nicht sprunghaft ändert, kann in vorteilhafterweise von einer sanften Abschaltung und einer sanften Zuschaltung des Prüfwiderstands gesprochen werden. Die Gefahr einer Übersteuerung der Regelstrecke sowie unerwünschte Überströme werden somit verhindert. Durch diesen Regelmechanismus bleibt der Regelkreis in seinem vorgesehenen Regelverhalten und führt zu der sanften Abschaltung und der sanften Zuschaltung.

Weiterhin weist die elektrische Schaltungsanordnung einen Mikrocontroller zur Vorgabe des Widerstands-Sollwertes über ein digitales Einstellelement und zur Ansteuerung der Schalteinrichtung mittels eines Schaltsignals auf.

Über den Mikrocontroller wird der Widerstands-Sollwert in digitaler Form vorgegeben und über das digitale Einstellelement als analoges Signal an den Eingang des Transformationsblocks weitergeleitet. Das digitale Einstellelement kann beispielsweise als digitales Potentiometer oder als Digital-Analog-Umsetzer ausgeführt sein.

Des Weiteren stellt der Mikrocontroller ein Schaltsignal zur Verfügung, welches unmittelbar oder, verknüpft mit weiteren Signalen (Überstrom-Signal, Übertemperatur-Signal), über eine Digitalschaltung der Schalteinrichtung zugeführt wird.

Mit Vorteil ist der Mikrocontroller dazu konfiguriert, ein amplitudenmoduliertes Widerstandsmuster aus zeitlich aufeinanderfolgenden Widerstands-Sollwerten vorzugeben.

Der Mikrocontroller kann dafür eingerichtet sein, eine definierte zeitliche Abfolge von unterschiedlichen Widerstands-Sollwerten vorzugeben, welche von dem Überwachungsgerät bei der Erfassung des Fehlerstroms als Signalfolge (Fehlerstromsignatur) erkannt wird, um eine bestimmte Aktion auszulösen. Beispielsweise kann dieses Widerstandsmuster als Startsignal für eine Prüfphase interpretiert werden.

In vorteilhafterweise weist die elektrische Schaltungsanordnung einen Übertemperatur-Detektor zur Erkennung einer Übertemperatur der Transistor-Kaskade und einen Überstrom-Detektor zur Erkennung eines Überlastwertes des Ist-Stroms auf, wobei ein Übertemperatur-Signal und ein Überstrom-Signal über eine Digitalschaltung mit einem Ausgangssignal des Mikrocontrollers zur Ansteuerung der Schalteinrichtung mittels des Schaltsignals verknüpft sind.

Die Zuverlässigkeit der erfindungsgemäßen elektrischen Schaltungsanordnung wird somit sichergestellt durch Sicherheitsabschaltungen bei Überstrom und/oder Übertemperatur der Transistor-Kaskade.

Vorzugsweise ist die Digitalschaltung als RS-Flip-Flop ausgeführt.

Da unabhängig von dem Schaltsignal des Mikrocontrollers ein Abschalten der Regelung durch die Sicherheitsfunktionen Überstrom- und Übertemperatur-Erkennung ermöglicht werden soll, ist die Digitalschaltung als RS-Flip-Flop ausgeführt. Ein Setzen des RS-Flip-Flops, also das Anschalten der Regelung, kann hierbei nur durch den Mikrocontroller erfolgen. Das Rücksetzen des RS-Flip-Flops, also das Ausschalten der Regelung, kann durch eine Oder-Verknüpfung von Überstrom-Signal, Übertemperatur-Signal und einem Ausgangssignal des Mikrocontrollers erfolgen.

Vorzugsweise ist der Regler als PI-Regler ausgeführt.

Als Regler gelangt in der Regelung ein PI-Regler zur Anwendung, der neben seinem proportionalen Verhalten (P-Anteil) einen überlagerten Integralanteil aufweist und damit zu keiner bleibenden Regelabweichung führt.

Mit Vorteil sind mehrere erfindungsgemäße Schaltungsanordnungen in einer modularen Schaltungsanordnung zusammengefügt, wobei jeder der elektrischen Schaltungsanordnungen ein anderer aktiver Leiter des elektrischen Stromversorgungssystems zugeordnet ist und eine zentrale Steuereinheit zur Steuerung und Überwachung der elektrischen Schaltungsanordnungen implementiert ist.

Die erfindungsgemäße elektrische Schaltungsanordnung, bestehend aus der Transistor-Kaskade und der Regelung, kann als Modul aufgefasst werden, welches mehrfach dupliziert werden kann, um Fehlerwiderstände (Prüfwiderstände) mit unterschiedlichen Werten zur gleichen Zeit an verschiedenen Stellen des Stromversorgungssystems einprägen zu können.

Um beispielsweise in einem dreiphasigen Wechselspannungs-Stromversorgungssystem für alle aktiven Leiter Prüfwiderstände gegen Erde schalten zu können, wird die erfindungsgemäße elektrische Schaltungsanordnung demzufolge dreimal benötigt und jeweils mit einem anderen aktiven Leiter verbunden. Diese Möglichkeit deckt damit in idealer Weise auch die Prüfung der normativen Anforderung zur Erkennung symmetrischer Isolationsfehler ab.

Die modulare Schaltungsanordnung verfügt über eine zentrale Steuereinheit, welche die gewünschten Widerstands-Sollwerte an die Module ausgibt und deren Funktion überwacht.

Weiterhin ist eine Kommunikationsverbindung zwischen der zentralen Steuereinheit und dem zu prüfenden Überwachungsgerät vorgesehen.

Über diese Kommunikationsverbindung können Daten in beiden Richtungen zwischen der zentralen Steuereinheit der modularen Schaltungsanordnung und dem Überwachungsgerät ausgetauscht werden, beispielsweise um Meldesignale von dem zu prüfenden Überwachungsgerät zu empfangen oder um eine genaue Auslösezeitmessung zu aktivieren. Andererseits kann über die Kommunikationsverbindung ausgehend von der modularen Schaltungsanordnung dem zu prüfenden Überwachungsgerät beispielsweise mitgeteilt werden, dass eine Prüfung eingeleitet werden soll.

Die Kommunikationsverbindung kann drahtgebunden oder drahtlos ausgeführt sein.

Die zuvor beschriebene erfindungsgemäße elektrische Schaltungsanordnung beruht auf einem Verfahren zur Funktionsprüfung eines Überwachungsgerätes für ein elektrisches Stromversorgungssystem, bei dem ein Prüfwiderstand mit einem einstellbaren Widerstandswert zwischen einem aktiven Leiter des Stromversorgungssystems und Erde geschaltet wird. Dabei ist der Prüfwiderstand als bidirektionale Kaskade aus Feldeffekttransistoren ausgeführt und das Einstellen des Widerstandswertes auf einen vorgebbaren Widerstands-Sollwert erfolgt wertkontinuierlich mittels einer analogen Regelung.

Insoweit treffen auch die vorgenannten für die elektrische Schaltungsanordnung zutreffenden technischen Wirkungen und daraus resultierenden Vorteile auf die Verfahrensmerkmale zu.

Insbesondere erfolgt ausgehend von einem als bidirektionale Kaskade aus Feldeffekttransistoren ausgeführten Prüfwiderstand das Einstellen des Widerstandswertes auf einem vorgebbaren Widerstands-Sollwert wertkontinuierlich mittels einer analogen Regelung und ermöglicht somit bei minimierter Baugröße und minimiertem Materialaufwand eine flexible Anpassung an die Systemumgebung und an prüftechnische Vorgaben.

Das Verfahren kann darüber hinaus in Kombination mit einer zentralen Steuereinheit in einer modularen Schaltungsanordnung für ein mehrphasiges Stromversorgungssystem in der Weise angewendet werden, dass mehreren aktiven Leitern jeweils ein angepasster Prüfwiderstand zugeordnet wird. Dabei wird der jeweilige aktive Leiter mit einer erfindungsgemäßen Schaltungsanordnung verbunden und individuell ein Prüfwiderstand mit definiertem Widerstandswert eingestellt.

Weitere vorteilhafte Ausgestaltungsmerkmale ergeben sich aus der nachfolgenden Beschreibung und den Zeichnungen, die eine bevorzugte Ausführungsform der Erfindung anhand von Beispielen erläutern.

Es zeigen:
- **Fig. 1**: Prüfanordnung mit veränderbaren Prüfwiderständen gemäß dem Stand der Technik zur Funktionsprüfung eines Isolationsüberwachungsgerätes;
- **Fig. 2**: ein Kennlinienfeld einer bidirektionalen MOSFET-Transistor-Kaskade;
- **Fig. 3**: eine erfindungsgemäße elektrische Schaltungsanordnung mit Transistor-Kaskade und analoger Regelung und
- **Fig. 4**: eine modulare Schaltungsanordnung mit zwei erfindungsgemäßen Schaltungsanordnungen.

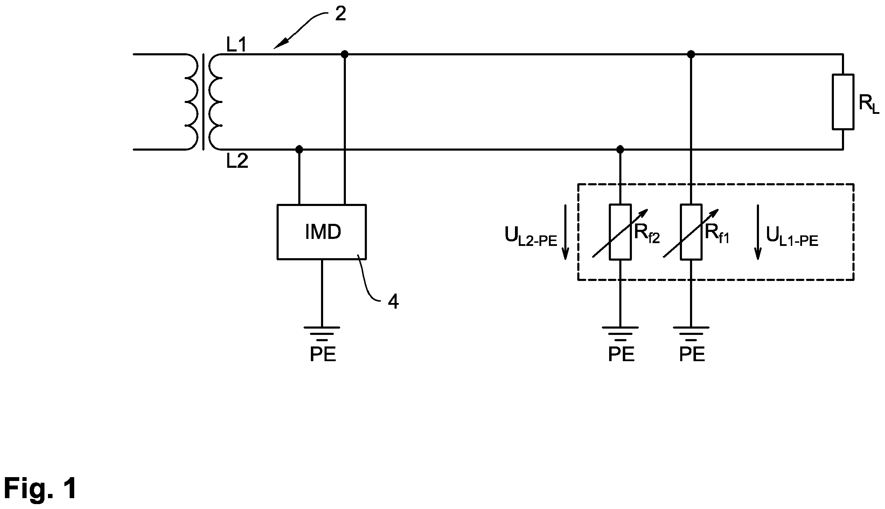

**Fig. 1** zeigt eine den Stand der Technik gemäße Prüfanordnung mit veränderbaren Prüfwiderständen zur Funktionsprüfung eines in einem ungeerdeten Stromversorgungssystem 2 installierten Isolationsüberwachungsgerätes 4.

Das Stromversorgungssystem 2 weist zwei aktive Leiter L1, L2 auf, an die ein Verbraucher R_{L} geschaltet ist. Das Isolationsüberwachungsgerät 4 ist zur Isolationswiderstandsmessung (Messung des Fehlerwiderstands in dem Stromversorgungssystem 2) mit den aktiven Leiter L1, L2 und Erde (Erdpotenzial) PE verbunden.

Zur Erzeugung eines definierten Fehlerwiderstands sind jeweils zwischen einem aktiven Leiter L1, L2 und Erde PE veränderbare Prüfwiderstände R_{f1}, R_{f2} angeordnet, über die jeweils die Leiter-Erde-Spannung U_{L1-PE}, U_{L2-PE} abfällt. Für die Funktionsprüfung des Isolationsüberwachungsgerätes 4 wird ein geschlossener Messkreis über jeweils einen aktiven Leiter L1, L2, die Prüfwiderstände R_{f1}, R_{f2} und Erde PE zurück zu dem Isolationsüberwachungsgerät 4 ausgebildet, in dem ein Fehlerstrom (Messstrom) fließt, der in dem Isolationsüberwachungsgerät 4 ausgewertet werden kann.

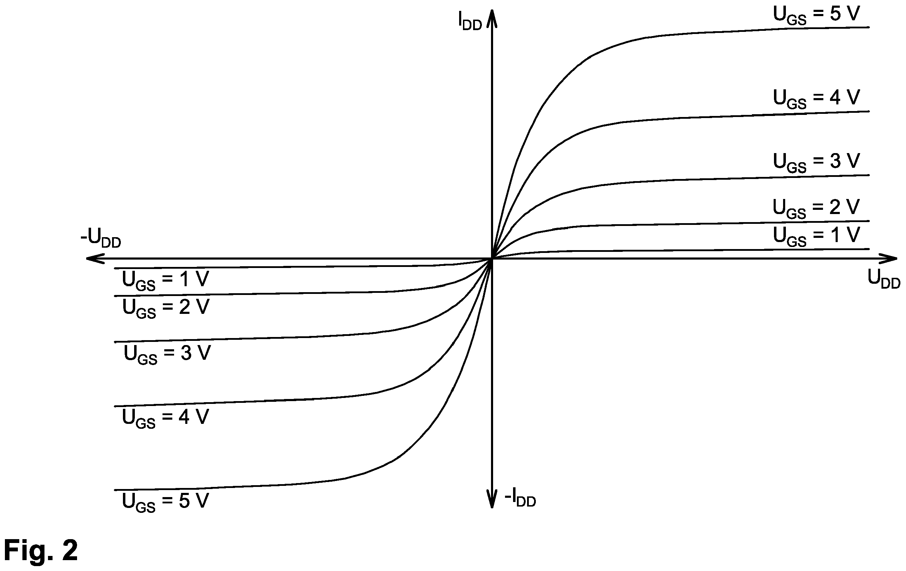

In **Fig. 2** ist ein Kennlinienfeld der bidirektionalen MOSFET-Transistor-Kaskade dargestellt.

Vorzugsweise werden als Transistoren MOSFETs verwendet. In Abhängigkeit der Steuerspannung U_{GS} stellt sich bei über der Transistor-Kaskade angelegten Spannung U_{DD} ein bestimmter über die Kaskade fließender Strom I_{DD} ein.

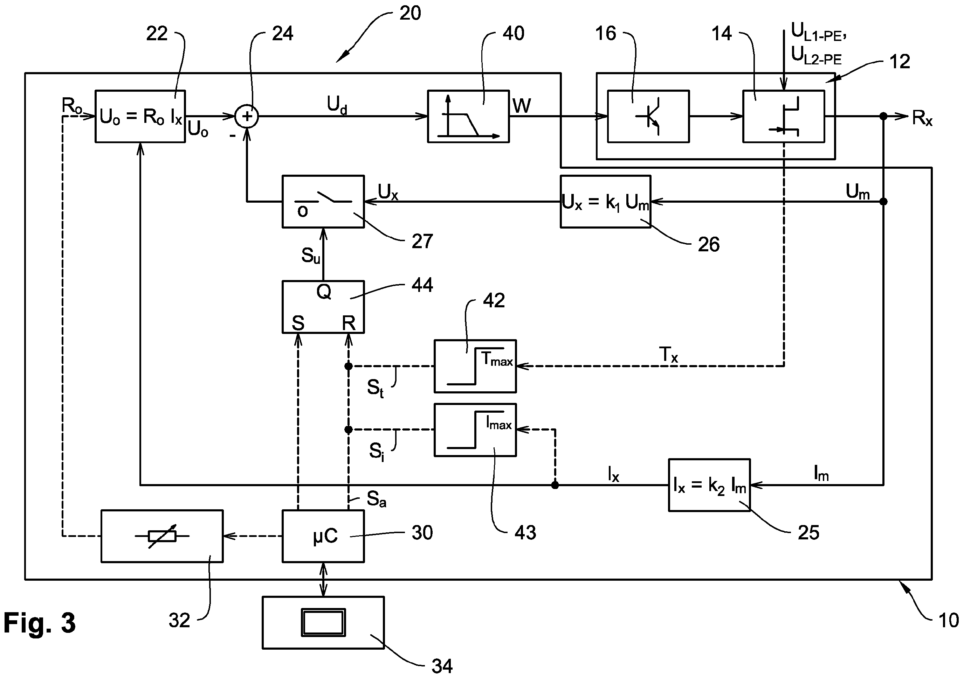

Die bidirektionale Transistor-Kaskade 12 besteht aus einer Reihenschaltung von zwei spiegelbildlich angeordneten MOSFET-Transistoren, sodass sich Arbeitsbereiche der Transistor-Kaskade 12 in dem ersten und dritten Quadranten des Kennlinienfeldes ergeben. Durch die analoge Regelung 10 (Fig. 3) wird die Transistor-Kaskade 12 in ein ohmsches Verhalten gezwungen.

**Fig. 3** zeigt die erfindungsgemäße elektrische Schaltungsanordnung 20 mit bidirektionaler Transistor-Kaskade 12 und Regelung 10.

Als Eingangsgröße der Regelung 10 wird zunächst der gewünschte Widerstands-Sollwert R₀ vorgegeben, welcher über den Transformationsblock 22 in die Sollspannung U₀ transformiert wird. Die Transformation erfolgt über die Strommessung 25, die den über die Transistor-Kaskade 12 fließenden Transistorstrom Iₘ (entspricht I_{DD} in Fig. 2) erfasst und skaliert (k₂) als Ist-Strom Iₓ dem Transformationsblock 22 zuführt.

In dem Vergleichsglied 24 wird aus der Sollspannung U₀ und der Ist-Spannung Uₓ, welche über die Spannungsmessung 26 aus der über der Transistor-Kaskade 12 abfallenden Transistorspannung Uₘ gewonnen und skaliert (k₁) wird, eine Differenzspannung U_{d} gebildet. Die Differenzspannung U_{d} wird dem Regler 40 - der vorzugsweise ein PI-Regler ist - zugeführt, der daraus eine Stellgröße W zur Ansteuerung der Transistor-Kaskade 12 bildet.

Die Transistor-Kaskade 12 umfasst neben einer eigentlichen Transistorstrecke 14 eine Treiberschaltung 16 zur Ansteuerung der Transistorstrecke 14.

Die Regelung 10 bewirkt, dass sich der Widerstands-Istwert Rₓ der Transistorstrecke 14 der Transistor-Kaskade 12 auf den vorgegebenen Widerstands-Sollwert R₀ einstellt.

Um die Regelung 10 ein- und ausschalten zu können, insbesondere aber um ein sanftes Herunterfahren und Anlaufen zu bewirken, ist zwischen der Spannungsmessung 26 und dem Vergleichsglied 24 eine Schalteinrichtung 27 vorgesehen, welche die Ist-Spannung Uₓ auf den Wert Null (Massepotential) zieht.

Die Schalteinrichtung 27 kann direkt mittels eines Schaltsignals Sᵤ von dem Mikrocontroller 30 oder über die Digitalschaltung 44 angesteuert werden.

Die als RS-Flip-Flop ausgeführte Digitalschaltung 44 ist dann vorzusehen, wenn mittels eines Übertemperatur-Detektors 42 eine Ist-Temperatur Tₓ der Transistor-Kaskade 12 und/oder mittels eines Überstrom-Detektors 43 ein unzulässig hoher Wert des Ist-Stroms Iₓ festgestellt wird und an dem Ausgang des Übertemperatur-Detektors 42 und/oder des Überstrom-Detektors 43 ein Übertemperatur-Signal Sₜ und/oder ein Überstromsignal Sᵢ ausgegeben wird. Das Übertemperatur-Signal Sₜ und das Überstrom-Signal Sᵢ werden über das RS-Flip-Flop 44 mit einem Ausgangssignal Sₐ des Mikrocontrollers 30 zu dem Schaltsignal Sᵤ verknüpft, welches die Schalteinrichtung 27 steuert.

Der Mikrocontroller 30 gibt über ein digitales Einstellelement 32 den Widerstands-Sollwert R₀ als Führungsgröße vor.

Zur übergeordneten Steuerung kann der Mikrocontroller 30 mit einem Steuergerät 34 wie beispielsweise einem PC, Laptop, Smartphone oder einer speicherprogrammierbaren Steuerung (SPS) verbunden werden.

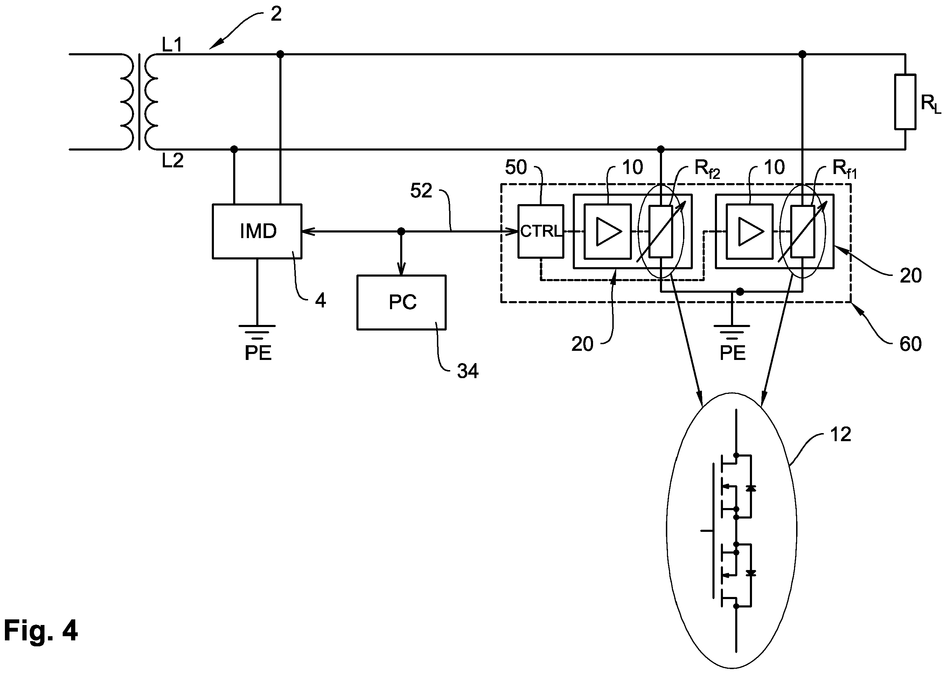

**Fig. 4** zeigt eine modulare Schaltungsanordnung 60 mit zwei erfindungsgemäßen Schaltungsanordnungen 20.

Die erfindungsgemäße Schaltungsanordnung 20 wird dabei jeweils als ein Modul aufgefasst, welches gleichzeitig unterschiedliche Fehlerwiderstände R_{f1}, R_{f2} an unterschiedlichen Stellen, beispielsweise an verschiedenen aktiven Leitern L1, L2 des Stromversorgungssystems 2 einprägt.

Vorliegend ist die erste erfindungsgemäße elektrische Schaltungsanordnung 20 an den aktiven Leiter L1, die zweite erfindungsgemäße elektrische Schaltungsanordnung 20 an den Leiter L2 jeweils gegen Erde angeschlossen. Beide elektrischen Schaltungsanordnungen 20 werden von einer zentralen Steuereinheit 50 gesteuert.

Die zentrale Steuereinheit 50 ist über eine Kommunikationsverbindung 52 mit dem zu prüfenden Isolationsüberwachungsgerät 4 verbunden. Über diese Kommunikationsverbindung 52 können beliebige Daten insbesondere aber Daten zur Signalisierung zwischen der modularen Schaltungsanordnung 60 und dem Isolationsüberwachungsgerät 4 ausgetauscht werden.

Die Kommunikationsverbindung 52 selbst kann drahtgebunden oder drahtlos ausgeführt und in ein gemeinsames Datennetzwerk mit dem Steuergerät 34 eingebunden sein.

## Patentansprüche

1. Elektrische Schaltungsanordnung (20) zur Funktionsprüfung eines Überwachungsgerätes (4) für ein Stromversorgungssystem (2), mit einem Prüfwiderstand (R_{f1}, R_{f2}), der zwischen einen aktiven Leiter L₁, L₂) des Stromversorgungssystems (2) und Erde (PE) schaltbar ist und einen einstellbaren Widerstands-Istwert (Rx) aufweist,
mit einer bidirektionalen Kaskade (12) mit Feldeffekttransistoren als Prüfwiderstand (R_{f1}, R_{f2}) und einer analogen Regelung (10) zur wertkontinuierlichen Einstellung des Widerstands-Istwertes (Rx) auf einen vorgebbaren Widerstands-Sollwert (R₀), wobei die Regelung aufweist
einen Transformationsblock (22), welcher mittels eines Ist-Stroms (Iₓ) den vorgebbaren Widerstands-Sollwert (R₀) in eine Soll-Spannung (U₀) als Führungsgröße transformiert;
eine Strommessung (25), welche einen durch die Transistor-Kaskade (12) fließenden Transistor-Strom (Iₘ) erfasst und skaliert als den Ist-Strom (Iₓ) in den Transformationsblock (22) zurückführt;
ein Vergleichsglied (24), welches die Soll-Spannung (U₀) mit einer Ist-Spannung (Uₓ) vergleicht und eine Differenzspannung (U_{d}) als Regelabweichung bildet;
eine Spannungsmessung (26), welche eine über der Transistor-Kaskade (12) abfallende Transistor-Spannung (Uₘ) erfasst und skaliert als die Ist-Spannung (Uₓ) in das Vergleichsglied (24) zurückführt;
einen Regler (40), der aus der Differenzspannung (U_{d}) eine Stellgrö-ße (W) zur Ansteuerung einer Regelstrecke erzeugt, die durch die Transistor-Kaskade (12) mit dem Widerstandswert als Regelgröße (Rₓ) gebildet ist;
**gekennzeichnet durch**
eine steuerbare Schalteinrichtung (27), welche die Ist-Spannung (Uₓ) auf den Wert Null schaltet, um die Regelung (10) herunterzufahren und ein sanftes Abschalten und Zuschalten des Prüfwiderstands (R_{f1}, R_{f2}) zu bewirken.

2. Elektrische Schaltungsanordnung (20) nach Anspruch 1,
**gekennzeichnet durch**
einen Mikrocontroller (30) zur Vorgabe des Widerstands-Sollwertes (R₀) über ein digitales Einstellelement (32) und zur Ansteuerung der Schalteinrichtung (27) mittels eines Schaltsignals (Sᵤ).

3. Elektrische Schaltungsanordnung (20) nach Anspruch 2,
**dadurch gekennzeichnet,**
**dass** der Mikrocontroller (30) dazu konfiguriert ist, ein amplitudenmoduliertes Widerstandsmuster aus zeitlich aufeinanderfolgenden Widerstands-Sollwerten (R₀) vorzugeben.

4. Elektrische Schaltungsanordnung (20) nach Anspruch 2 oder 3,
**dadurch gekennzeichnet,**
**dass** die Regelung (10) einen Übertemperatur-Detektor (42) zur Erkennung einer Übertemperatur der Transistor-Kaskade (12) und einen Überstrom-Detektor (43) zur Erkennung eines Überlastwertes des Ist-Stroms (Iₓ) aufweist, wobei ein Übertemperatur-Signal (Sₜ) und ein Überstrom-Signal (Sᵢ) über eine Digitalschaltung (44) mit einem Ausgangssignal (Sₐ) des Mikrocontrollers (30) zur Ansteuerung der Schalteinrichtung (27) verknüpft sind.

5. Elektrische Schaltungsanordnung (20) nach Anspruch 4,
**dadurch gekennzeichnet,**
**dass** die Digitalschaltung (44) als RS-Flip-Flop ausgeführt ist.

6. Elektrische Schaltungsanordnung (20) nach einem der Ansprüche 1 bis 5,
**dadurch gekennzeichnet,**
**dass** der Regler (40) als PI-Regler ausgeführt ist.

7. Modulare Schaltungsanordnung (60) bestehend aus mehreren elektrischen Schaltungsanordnungen (20) nach einem der Ansprüche 1 bis 6,
**dadurch gekennzeichnet,**
**dass** jeder der elektrischen Schaltungsanordnungen (20) ein anderer aktiver Leiter (L₁, L₂) des elektrischen Stromversorgungssystems (2) zugeordnet ist und eine zentrale Steuereinheit (50) zur Steuerung und Überwachung der elektrischen Schaltungsanordnungen (20) implementiert ist.

8. Modulare Schaltungsanordnung (60) nach Anspruch 7,
**gekennzeichnet durch**
eine Kommunikationsverbindung (52) zwischen der zentralen Steuereinheit (50) und dem Überwachungsgerät (4).

9. Verfahren zur Funktionsprüfung eines Überwachungsgerätes (4) für ein elektrisches Stromversorgungssystem (2), umfassend die Verfahrensschritte
Schalten eines Prüfwiderstands (R_{f1}, R_{f2}) mit einem einstellbaren Widerstands-Istwert (Rx) zwischen einen aktiven Leiter (L₁, L₂) des Stromversorgungssystems (2) und Erde (PE),
**dadurch gekennzeichnet, dass**
der Prüfwiderstand (R_{f1}, R_{f2}) eine bidirektionale Kaskade (12) aus Feldeffekttransistoren ist und das Einstellen des Widerstands-Istwertes (Rx) auf einen vorgebbaren Widerstands-Sollwert (R₀) wertkontinuierlich mittels einer analogen Regelung (10) erfolgt.

10. Verfahren nach Anspruch 9,
**dadurch gekennzeichnet,**
**dass** durch die Regelung (10)
in einem Transformationsblock (22) mittels eines Ist-Stroms (Iₓ) der vorgebbare Widerstands-Sollwert (R₀) in eine Soll-Spannung (U₀) als Führungsgröße transformiert wird;
mit einer Strommessung (25) ein durch die Transistor-Kaskade (12) fließenden Transistor-Strom (Iₘ) erfasst und skaliert als der Ist-Strom (Iₓ) in den Transformationsblock (22) zurückgeführt wird; in einem Vergleichsglied (24) die Soll-Spannung (U₀) mit einer Ist-Spannung (Uₓ) verglichen und eine Differenzspannung (U_{d}) als Regelabweichung gebildet wird;
mit einer Spannungsmessung (26) eine über der Transistor-Kaskade (12) abfallende Transistor-Spannung (Uₘ) erfasst und skaliert als die Ist-Spannung (Uₓ) in das Vergleichsglied (24) zurückgeführt wird; mittels eines Reglers (40) aus der Differenzspannung (U_{d}) eine Stellgröße (W) zur Ansteuerung einer Regelstrecke erzeugt wird, wobei die Regelstrecke durch die Transistor-Kaskade (12) mit dem Widerstands-Istwert (Rx) als Regelgröße gebildet wird und
mit einer steuerbaren Schalteinrichtung (27) die Ist-Spannung (Uₓ) auf den Wert Null geschaltet wird, um die Regelung (10) herunterzufahren.

11. Verfahren nach Anspruch 10,
**dadurch gekennzeichnet,**
**dass** ein Mikrocontroller (30) den Widerstands-Sollwert (R₀) über ein digitales Einstellelement (32) vorgibt und mittels eines Schaltsignals die Schalteinrichtung (27) ansteuert.

12. Verfahren nach Anspruch 11,
**dadurch gekennzeichnet,**
**dass** der Mikrocontroller (30) ein amplitudenmoduliertes Widerstandsmuster aus zeitlich aufeinanderfolgenden Widerstands-Sollwerten (R₀) vorgibt.

13. Verfahren nach Anspruch 11 oder 12,
**gekennzeichnet durch**
Erkennen einer Übertemperatur der Transistor-Kaskade in der Regelung (10) mittels eines Übertemperatur-Detektors (42);
Erkennen eines Überlastwertes des Ist-Stroms (Iₓ) mittels eines Überstrom-Detektors (43), wobei ein Übertemperatur-Signal (Sₜ) und ein Überstrom-Signal (Sᵢ) über eine Digitalschaltung (44) mit einem Ausgangssignal (Sₐ) des Mikrocontrollers (30) zur Ansteuerung der Schalteinrichtung (27) verknüpft werden.

14. Verfahren nach Anspruch 13,
**dadurch gekennzeichnet,**
**dass** die Digitalschaltung (44) als RS-Flip-Flop implementiert wird.

15. Verfahren nach einem der Ansprüche 10 bis 14,
**dadurch gekennzeichnet,**
**dass** der Regler (40) eine PI-Regelung ausführt.

## Claims

1. An electric circuit arrangement (20) for the functional testing of a monitoring device (4) for a power supply system (2), the electric circuit arrangement (20) having a test resistance (R_{f1}, R_{f2}) which is switched between an active conductor (L₁, L₂) of the power supply system (2) and ground (PE) and has a settable actual resistance value (Rₓ), having a bidirectional cascade (12) consisting of field-effect transistors as test resistances (R_{f1}, R_{f2}) and by an analog control (10) for the continuous-value setting of the actual resistance value (Rₓ) to a predeterminable target resistance value (R₀), the control (10) comprising
a transformation block (22) which transforms the predeterminable target resistance value (R₀) to a target voltage (U₀) as a reference variable by means of an actual current (Iₓ);
a current measurement (25) which detects a transistor current (Iₘ) flowing through the transistor cascade (12) and supplies the transistor current (Iₘ) to the transformation block in a scaled manner as the actual current (Iₓ);
a comparison element (24) which compares the target voltage (U₀) to an actual voltage (Uₓ) and forms a differential voltage (U_{d}) as a control deviation;
a voltage measurement (26) which detects a transistor voltage (Uₘ) dropping via the transistor cascade (12) and supplies the transistor voltage (Uₘ) to the comparison element (24) in a scaled manner as the actual voltage (Uₓ);
a controller (40) which generates an actuating variable (W) from the differential voltage (U_{d}) for controlling a control path which is formed by the transistor cascade (12) having the resistance value as a control variable (Rₓ);
**characterized by**
a controllable switch device (27) which switches the actual voltage (Uₓ) to zero to shut down the control (10) and causes a soft shutoff and switching of the test resistance (R_{f1}, R_{f2}).

2. The electric circuit arrangement (20) according to claim 1,
**characterized by**
a microcontroller (30) for predetermining the target resistance value (Ra) via a digital setting element (32) and for controlling the switch device (27) by means of a switch signal (Sᵤ).

3. The electric circuit arrangement (20) according to claim 2,
**characterized in that**
the microcontroller (30) is configured for specifying an amplitude-modulated resistance pattern from consecutive target resistance values (R₀).

4. The electric circuit arrangement (20) according to claim 2 or 3,
**characterized in that**
the control (10) comprises an overtemperature detector (42) for detecting an overtemperature of the transistor cascade (12) and an overcurrent detector (43) for detecting an overload value of the actual current (Iₓ), an overtemperature signal (St) and an overcurrent signal (Si) being merged with an output signal (Sₐ) of the microcontroller (30) via a digital circuit (44) for controlling the switch device (27).

5. The electric circuit arrangement (20) according to claim 4,
**characterized in that**
the digital circuit (44) is realized as a set-reset flipflop.

6. The electric circuit arrangement (20) according to any of the claims 1 to 5,
**characterized in that**
the controller (40) is realized as a PI controller.

7. A modular circuit arrangement (60) consisting of several electric circuit arrangements (20) according to any of the claims 1 to 6,
**characterized in that**
each of the electric circuit arrangements (20) is assigned a different active conductor (L₁, L₂) of the electric power supply system (2), and a central control unit (50) is implemented for controlling and monitoring the electric circuit arrangements (20).

8. The modular circuit arrangement (60) according to claim 7,
**characterized by**
a communication connection (52) between the central control unit (50) and the monitoring device (4).

9. A method for the functional testing of a monitoring device (4) for an electric power supply system (2), the method comprising the following steps:
switching a test resistance (R_{f1}, R_{f2}) having a settable actual resistance value (Rₓ) between an active conductor (L₁, L₂) of the power supply system (2) and ground (PE),
**characterized in that**
the test resistance (R_{f1}, R_{f2}) is a bidirectional cascade (12) consisting of field-effect transistors and **in that** the setting of the actual resistance value (Rₓ) to a predeterminable target resistance value (R₀) takes place in a continuous-value manner by means of an analog control (10).

10. The method according to claim 9,
**characterized in that**
via the control (10)
the predeterminable target resistance value (R₀) is transformed to a target voltage (U₀) in a transformation block (22) as a reference variable by means of an actual current (Iₓ);
a current measurement device (25) detects a transistor current (Iₘ) flowing through the transistor cascade (12) and supplies the transistor current (Iₘ) to the transformation block (22) in a scaled manner as the actual current (Iₓ);
the target voltage (U₀) is compared to an actual voltage (Uₓ) in a comparison element (24) and a differential voltage (U_{d}) is formed as a control deviation;
a voltage measurement device (26) detects a transistor voltage (Uₘ) dropping via the transistor cascade (12) and supplies the transistor voltage (Uₘ) to the comparison element (24) in a scaled manner as the actual voltage (Uₓ);
an actuating variable (W) is generated from the differential voltage (U_{d}) by means of a controller (40) in order to control a control path, which is formed by the transistor cascade (12) having the actual resistance value (Rₓ) as a control variable; and
a controllable switch device (27) switches the actual voltage (Uₓ) to zero to shut down the control (10).

11. The method according to claim 10,
**characterized in that**
a microcontroller (30) specifies the target resistance value (R₀) via a digital setting element (32) and controls the switch device (27) by means of a switch signal.

12. The method according to claim 11,
**characterized in that**
the microcontroller (30) specifies an amplitude-modulated resistance pattern from consecutive target resistance values (R₀).

13. The method according to claim 11 or 12,
**characterized by**
detecting an overtemperature of the transistor cascade in the control (10) by means of an overtemperature detector (42); detecting an overload value of the actual current (Iₓ) by means of an overcurrent detector (43), an overtemperature signal (St) and an overcurrent signal (Si) being merged with an output signal (Sₐ) of the microcontroller (30) via a digital circuit (44) for controlling the switch device (27).

14. The method according to claim 13,
**characterized in that**
the digital circuit (44) is implemented as a set-reset flipflop.

15. The method according to any of the claims 10 to 14,
**characterized in that**
the controller (40) performs a PI control.

## Revendications

1. Arrangement de circuit (20) électrique pour l'essai fonctionnel d'un dispositif de surveillance (4) pour un système d'alimentation électrique (2), l'arrangement de circuit (20) électrique ayant une résistance d'essai (R_{f1}, R_{f2}) qui peut être commutée entre un conducteur actif (L₁, L₂) du système d'alimentation électrique (2) et la terre (PE) et qui a une valeur réelle de résistance (Rₓ) ajustable, ayant une cascade bidirectionnelle (12) consistant en des transistors à effet de champ comme résistance d'essai (R_{f1}, R_{f2}) et un réglage analogue (10) pour l'ajustement continu de la valeur réelle de résistance (Rₓ) à une valeur cible de résistance (R₀) prédéterminable, le réglage (10) comprenant
un bloc de transformation (22) qui transforme la valeur cible de résistance (R₀) prédéterminable en une tension cible (U₀) comme variable de référence au moyen d'un courant réel (Iₓ) ;
une mesure de courant (25) qui détecte un courant de transistor (Iₘ) écoulant par la cascade de transistor (12) et qui alimente le bloc de transformation en courant de transistor (Iₘ) mis à l'échelle comme courant réel (Iₓ) ;
un comparateur (24) qui compare la tension cible (U₀) à une tension réelle (Uₓ) et qui forme une tension différentielle (U_{d}) comme écart de réglage ;
une mesure de tension (26) qui détecte une tension de transistor (Uₘ) chutant par la cascade de transistor (12) et qui alimente le comparateur (24) en tension de transistor (Uₘ) mis à l'échelle comme tension réelle (Uₓ) ;
un régulateur (40) qui génère une variable réglant (W) à partir de la tension différentielle (U_{d}) pour le contrôle d'un boucle de régulation qui est formé par la cascade de transistor (12) ayant la valeur de résistance comme variable réglée (Rₓ) ;
**caractérisé par**
un dispositif de commutation (27) contrôlable qui commute la tension réelle (Uₓ) à zéro afin d'éteindre le régulateur (10) et afin de provoquer une coupure douce et une commutation de la résistance d'essai (R_{f1}, R_{f2}).

2. Arrangement de circuit (20) électrique selon la revendication 1,
**caractérisé par**
un microcontrôleur (30) pour la prédétermination de la valeur cible de résistance (R₀) par un élément d'ajustement (32) digital et pour le contrôle du dispositif de commutation (27) au moyen d'un signal de commutation (Sᵤ).

3. Arrangement de circuit (20) électrique selon la revendication 2,
**caractérisé en ce que**
le microcontrôleur (30) est configuré pour la spécification d'un modèle de résistance en modulation d'amplitude à partir de valeurs cibles de résistance (R₀) consécutives.

4. Arrangement de circuit (20) électrique selon la revendication 2 ou la revendication 3,
**caractérisé en ce que**
le régulateur (10) comprend un détecteur de surtémperature (42) pour la détection d'une surtémperature de la cascade de transistor (12) et un détecteur de surintensité (43) pour la détection d'une valeur de surcharge du courant réel (Iₓ), un signal de surtémperature (St) et un signal de surintensité (Si) étant associés à un signal de sortie (Sₐ) du microcontrôleur (30) par un circuit digital (44) pour le contrôle du dispositif de commutation (27).

5. Arrangement de circuit (20) électrique selon la revendication 4,
**caractérisé en ce que**
le circuit digital (44) est réalisé comme bascule bistable RS.

6. Arrangement de circuit (20) électrique selon l'une quelconque des revendications 1 à 5,
**caractérisé en ce que**
le régulateur (40) est réalisé comme régulateur PI.

7. Arrangement de circuit (60) modulaire consistant en plusieurs arrangements de circuit (20) électriques selon l'une quelconque des revendications 1 à 6,
**caractérisé en ce que**
chaque arrangement de circuit (20) électrique est associé à un autre conducteur actif (L₁, L₂) du système d'alimentation électrique (2), et **en ce qu'**une unité de contrôle (50) centrale est implémentée pour le contrôle et pour la surveillance de l'arrangement de circuit (20) électrique.

8. Arrangement de circuit (60) modulaire selon la revendication 7,
**caractérisé par**
une connexion de communication (52) entre l'unité de contrôle (50) centrale et le dispositif de surveillance (4).

9. Procédé pour l'essai fonctionnel d'un dispositif de surveillance (4) pour un système d'alimentation électrique (2), le procédé comprenant les étapes suivantes :
la commutation d'une résistance d'essai (R_{f1}, R_{f2}) ayant une valeur réelle de résistance (Rₓ) ajustable entre un conducteur actif (L₁, L₂) du système d'alimentation électrique (2) et la terre PE),
**caractérisé en ce que**
la résistance d'essai (R_{f1}, R_{f2}) est une cascade bidirectionnelle (12) consistant en transistors à effet de champ et **en ce que** l'ajustement de la valeur réelle de résistance (Rₓ) à une valeur cible de résistance (R₀) prédéterminable s'effectue continûment au moyen d'un régulateur analogue (10).

10. Procédé selon la revendication 9,
**caractérisé en ce que**
par le régulateur (10)
la valeur cible de résistance (R₀) prédéterminable est transformée en une tension cible (U₀) dans un bloc de transformation (22) comme variable de référence au moyen d'un courant réel (Iₓ) ; une mesure de courant (25) détecte un courant de transistor (Iₘ) écoulant par la cascade de transistor (12) et aliment le bloc de transformation (22) en courant de transistor (Iₘ) mis à l'échelle comme courant réel (Iₓ) ;
la tension cible (U₀) est comparée à une tension réelle (Uₓ) dans un comparateur (24) et une tension différentielle (U_{d}) est formée comme écart de réglage ;
une mesure de tension (26) détecte une tension de transistor (Uₘ) chutant par la cascade de transistor (12) et alimente le comparateur (24) en tension de transistor (Uₘ) mis à l'échelle comme tension réelle (Uₓ) ;
une variable réglant (W) est générée à partir de la tension différentielle (U_{d}) au moyen d'un régulateur (40) afin de contrôler une boucle de régulation, qui est formée par la cascade de transistor (12) ayant la valeur réelle de résistance (Rₓ) comme variable réglée ; et
un dispositif de commutation (27) contrôlable commute la tension réelle (Uₓ) à zéro afin d'éteindre le régulateur (10).

11. Procédé selon la revendication 10,
**caractérisé en ce**
**qu'**un microcontrôleur (30) spécifie la valeur cible de résistance (R₀) par un élément d'ajustement (32) digital et contrôle le dispositif de commutation (27) au moyen d'un signal de commutation.

12. The procédé selon la revendication 11,
**caractérisé en ce que**
le microcontrôleur (30) spécifie une modèle de résistance en modulation d'amplitude à partir de valeurs cibles de résistance (R₀) consécutives.

13. The procédé selon la revendication 11 ou la revendication 12,
**caractérisé par**
la détection d'une surtémperature de la cascade de transistor dans le régulateur (10) au moyen d'un détecteur de surtémperature (42) ;
la détection d'une valeur de surcharge du courant réel (Iₓ) au moyen d'un détecteur de surintensité (43), un signal de surtémperature (St) et un signal de surintensité (Si) étant associés avec un signal de sortie (Sₐ) du microcontrôleur (30) par un circuit digital (44) pour le contrôle du dispositif de commutation (27).

14. Procédé selon la revendication 13,
**caractérisé en ce que**
le circuit digital (44) est implémenté comme bascule bistable RS.

15. Procédé selon l'une quelconque des revendications 10 à 14,
**caractérisé en ce que**
le régulateur (40) exécute un contrôle PI.
